# EUROPEAN PATENT APPLICATION

(11) **EP 4 632 791 A1**
(43) Date of publication of application: **15.10.2025**
(21) Application number: 24169707.7
(22) Date of filing: 11.04.2024
(51) Int. Cl.: H01L 21/02, H01L 21/04, H01L 21/28

(54) **METHOD OF FORMING A SIC/GATE DIELECTRIC INTERFACE LAYER IN A SEMICONDUCTOR DEVICE**

(71) Applicant: Infineon Technologies AG, 85579 Neubiberg (DE)
(72) Inventor: RESCHER, Gerald, 9063 Maria Saal (AT); AICHINGER, Thomas, 9583 Faak am See (AT); MENDLER, David-Johannes, 9500 Villach (AT); BERENS, Judith Veronika, 9020 Klagenfurt am Wörthersee (AT)
(74) Representative: Infineon Patent Department

(57) **Abstract**

Herein, a method of forming a semiconductor device may comprise forming a semiconductor substrate comprising silicon carbide at a surface thereof, cleaning a surface area of the semiconductor substrate by removing oxide species, carbon clusters, or other contaminants, and forming a dielectric layer above the cleaned surface of the semiconductor substrate. The method further provides a surface passivation at the interface of the cleaned surface of the semiconductor substrate and the dielectric layer.

## Description

### TECHNICAL FIELD

The present disclosure generally relates to methods of forming silicon carbide (SiC) / gate dielectric interface layers in semiconductor devices, e.g. those comprising a silicon carbide body.

### BACKGROUND

Semiconductor devices based on silicon carbide (SiC) and similar semiconductor components having a gate dielectric layer (i.e. a gate oxide (GOX) layer) or gate dielectric stack above the silicon carbide substrate are widely used in a lot of microelectronic devices. Those microelectronic devices with SiC semiconductor material are used in power applications, high temperature applications, high frequency applications, among others. SiC has a wide band gap, high breakdown field, high saturation velocity, and high electron mobility. The SiC semiconductor material is also known as a good basis for growing high quality gate dielectric layers on or above it. However, the growth of gate dielectric layers such as gate oxide layers may cause the propagation of defects at the semiconductor-dielectric interface and, thus, may result in decreased device performance.

MOSFETs or diodes based on SiC, thus, still suffer from low electron mobility at the interface of SiC and the gate dielectric layer. Interface mobility can be enhanced by anneals in nitrogen atmosphere (e.g. nitric oxide). However, even after nitridation reaction, the mobility remains low compared to the SiC bulk mobility. Therefore, a significant part of the ON-resistance of a semiconductor device originates from the channel resistance. To compensate for the high channel resistance more active area is required, which results in higher costs.

Any improvements in channel mobility may result in a reduced channel resistance and, hence, ON-resistance, without the necessity of increasing the active area of the chip. Therefore, it is an objective of the present application to overcome at least some of the foregoing problems. More particularly, one object is to improve the channel mobility.

### SUMMARY

According to an embodiment, a method of forming a semiconductor device may comprise forming a semiconductor substrate comprising silicon carbide at a surface thereof, cleaning a surface area of the semiconductor substrate by removing oxide species, carbon clusters, or other contaminants, and forming a dielectric layer above the cleaned surface of the semiconductor substrate. The dielectric layer formation may be carried out without exposing the cleaned surface of the semiconductor substrate to an oxidizing atmosphere. In this case, the lack of an oxidizing atmosphere may be observed and maintained at least after the surface has been cleaned as described above and at least until the end of the dielectric layer formation. If technically possible and suitable, the whole process can be performed without exposing the processed surfaces to an oxidizing atmosphere to hinder or at least reduce the formation of native oxides, oxidic structures or rearrangement processes based on oxidative reactions at the surface of the cleaned SiC substrate.

The method further provides a surface passivation at the interface of the cleaned surface of the semiconductor substrate and the dielectric layer. Surface passivation may comprise any protection of the surface of the semiconductor substrate by passivation means such as, for example, a passivation layer or passivation components which are suitable for protecting the SiC substrate surface from reacting with oxidizing components or being contaminated by other contaminants or reaction products such as carbon contaminations obtained from decomposition reactions of SiC, for example. Passivation layer in this regard means a continuous or discontinuous layer made of passivation material and being within a range of one, two, three or even more atomic or molecular layers. Generally, the passivation layer thickness may be as less as possible, for example not more than 5 nm, more particular, not more than 2 nm, or less than about 1 nm, if this is suitable enough to reduce any reactions with oxidizing components in the atmosphere in which the SiC substrate is stored or handled.

It is assumed that the passivation at the interface between the SiC substrate and the dielectric layer may be responsible for the improved performance, especially for the improved channel mobility at the SiC / gate dielectric interface. Thus, the improved channel mobility may result in a reduced channel resistance and, hence, ON-resistance. This may reduce the costs and overall size of the semiconductor devices as the active area of the microelectronic devices may necessarily not be increased compared to the devices manufactured without the passivation of the SiC substrate.

Those skilled in the art will recognize additional features and advantages upon reading the following detailed description, and upon viewing the accompanying drawings.

### BRIEF DESCRIPTION OF THE DRAWINGS

The elements of the drawings are not necessarily to scale relative to each other, instead emphasis being placed upon illustrating the principles of the invention. Like reference numerals designate corresponding similar parts. The features of the various illustrated examples can be combined unless they exclude each other. Examples are depicted in the drawings and are detailed in the description which follows.
Figure 1 illustrates process steps of a method of forming a semiconductor device in line with a first embodiment of the present description.
Figure 2 illustrates the manufacturing of a semiconductor device in line with the first embodiment.
Figure 3 illustrates process steps of a method of forming a semiconductor device in line with a second embodiment of the present description.
Figure 4 illustrates the manufacturing of a semiconductor device in line with the second embodiment.
Figure 5 illustrates process steps of a method of forming a semiconductor device in line with a third embodiment of the present description.
Figure 6 illustrates the manufacturing of a semiconductor device in line with the third embodiment.

### DETAILED DESCRIPTION

In the following detailed description, semiconductor devices are based on wide bandgap materials, especially power semiconductor devices comprising SiC substrates, for example. Examples of such semiconductor devices with specific dielectric gate structures include metal oxide semiconductor field-effect transistors (MOSFETs), junction field-effect transistors (JFETs), or insulated gate bipolar transistors (IGBTs). Any other semiconductor devices with a dielectric gate structure are included in the general concept of the present disclosure even if they are not literally mentioned herein. Wide bandgap semiconductor devices generally are able to sustain breakdown voltages higher than conventional silicon power devices.

Those semiconductor devices may comprise a SiC body having a drift region of a first conductivity type, a body region of a second conductivity type, a source region of the first conductivity type and a gate structure comprising a gate electrode and a gate dielectric that isolates the gate electrode from the SiC body, wherein the gate structure is disposed adjacent to the source region, the body region and the drift region. Even though all examples are described with regard to semiconductor devices having a SiC body, the present concept may be implemented into other wide bandgap semiconductor devices based on, e.g., GaN, AlN, Ga₂O₃, and so forth.

In planar type semiconductor devices, for example, a gate structure may extend between the source region and the drain region. The gate structure may be disposed on a portion of the source region and a portion of the drain region. In some examples, a first source region and a second source region may be provided within one pnp junction. Other junctions such as npn junctions may fall within this concept as well. Then, the gate structure may be disposed on the SiC body and may be disposed on a portion of the first source region and on a portion of the second source region.

The semiconductor devices may be manufactured from semiconductor substrates wherein the substrate shapes and sizes can vary and include commonly used round wafers of different sizes, for example, between 50 to 450 mm in diameter. Any other semiconductor substrate forms and sizes may be used instead of the exemplified round wafers commonly used.

In line with the description herein, a semiconductor substrate may generally be any semiconductor substrate comprising a SiC body at its surface, for example, in the form of a SiC-based substrate or as an epitaxy layer on a substrate of any material suitably used as semiconductor material for microelectronic devices.

The dielectric layer provided above the SiC body, may be a single dielectric layer or a part of a complex gate structure comprising a gate electrode and a gate dielectric that isolates the gate electrode from the SiC body. The gate dielectric may be made of a regular gate dielectric material, e.g., silicon oxide, or a gate material providing a high-k value (e.g. 4 or higher) in the gate dielectric in a single layer or a multilayer laminate structure, for example. Combinations of silicon dioxide and high-k gate materials or combinations of different high-k gate materials, for example in stacks of periodic layers, may fall within the definition of the gate dielectric. Exemplified high-k dielectric materials are AlN (about 6.2 eV), HfO₂ (5.7 eV), ZrO₂ (5.6 eV), Ta₂O₅ (4.4 eV), and La₂O₅ (5.45 eV), or any combinations thereof. Exemplified gate electrodes may be from the poly-Si type or a metal gate electrode or from combination materials including a metal. Desired metal gate properties can be designed by specifically combining the gate dielectric with the respective metal gate electrode material.

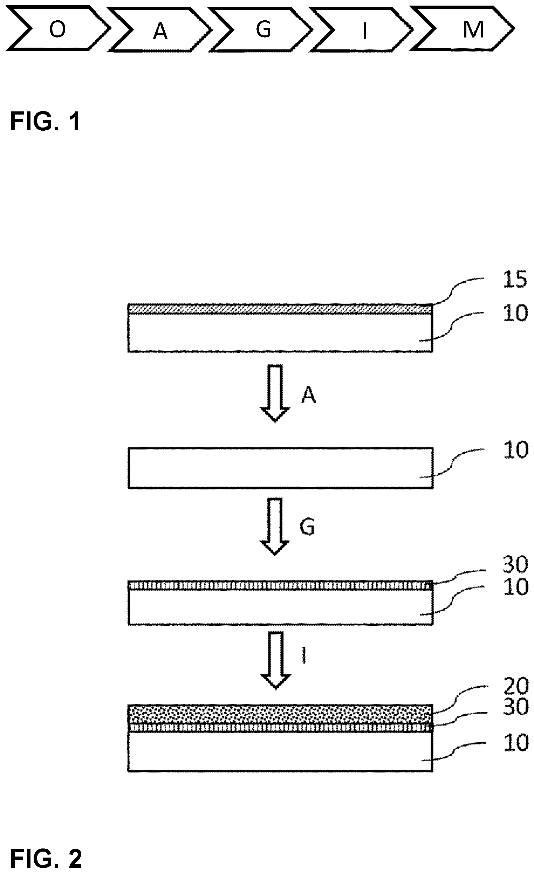

According to a first embodiment of the method of forming a semiconductor device the semiconductor substrate may be formed by any common method. This embodiment is described with regards to Figures 1 and 2 in greater detail. The step of forming a semiconductor substrate 10 is shown as step O in Figure 1. For example, the SiC substrate 10 may be manufactured or thinned by grinding or polishing the surface area of the substrate. Alternatively, a common trench structure may be provided having a SiC surface. It is usual that the freshly manufactured surface area is contaminated with native oxides or carbon containing contaminants shown as layer 15 in Figure 1. The layer 15 may be a continuous thin layer of a few nanometers or the surface may be contaminated by specific particles in a random distribution on the SiC surface 10. Therefore, according to this embodiment, the surface area of the semiconductor substrate 10 may be cleaned by removing oxide species, carbon clusters, or other contaminants 15. This step is synonymously called precleaning step or, if hydrogen comprising agents are used, H₂ precleaning A in some embodiments described herein and is different to any commonly used plasma or wet cleaning steps carried out after the semiconductor substrate surface is polished to its regular thickness and chemically cleaned by common methods, such as rinsing with water. Moreover, implants, high temperature (HTA) annealing, trench etching, trench rounding and sacrificial oxide (SACOX) including multiple standard (STD) cleanings (e.g. RCA cleaning using components like "SC1" or "SC2", diluted HF, buffered HF, "Piranha" agent and combinations thereof) to remove macroscopic defects and resist remainders usually can be done before the precleaning as described herein.

In some examples, the cleaned surface of the SiC substrate 10 may then be passivated in order to prepare the surface for dielectric deposition (Step G). After the cleaning and passivation, a dielectric layer may be formed (Step I), e.g. deposited by a deposition method or formed in situ by oxidizing reaction, on the passivated surface of the semiconductor substrate. According to these examples, a passivation layer 30 or a passivated surface of the SiC substrate 10 is provided between the SiC and the dielectric layer 20, manufactured of a gate dielectric material. In other words, a passivation layer 30 may be provided at the SiC / dielectric interface of the semiconductor device. In some examples, the H₂ preclean treatment (Step A,) forming a passivation layer (Step G) and the SiC / dielectric interface formation (Step I) may be carried out in one process furnace without exposing the cleaned surface to an oxidizing atmosphere. Generally, those treatments may be carried out under reduced pressure. Thus, they may be carried out in one process furnace without breaking the vacuum between the respective processing steps.

The cleaning may be a preclean treatment using gaseous agents (e.g. fluids) which provide a non-oxidizing atmosphere within the cleaning furnace or cleaning chamber. In some examples, the cleaning of the surface area, that means the preclean, comprises treating the semiconductor substrate surface with a gaseous precleaning agent. Exemplified gaseous agents for the preclean treatment (Step A) are, e.g., agents such as fluids comprising non-oxidative species, such as hydrogen or hydrochloric acid. In some examples, the cleaning may comprise exposing the semiconductor substrate surface to hydrogen or hydrochloric gas atmosphere, in some particular examples hydrogen may be used for this preclean treatment.

The preclean treatment may be carried out at a time, temperature, and pressure that is adjusted to clean or to passivate or to clean and passivate the surface without major surface rearrangement. If the preclean is carried out using hydrogen (H₂) as gaseous agent, exemplified temperature ranges are below 1350 °C and pressure ranges are below 0.1 MPa. In some exemplary embodiments, the temperature may be adjusted to be lower than 1350 °C, but higher than 1000 °C.

According to some examples, the method further provides a surface passivation at the interface of the cleaned surface of the semiconductor substrate and the dielectric layer. Surface passivation may comprise any protection of the surface of the semiconductor substrate by passivation means such as, for example, a passivation layer or the like. It is also possible that the passivation layer is not a discrete layer but consists of specific passivation particles or components. In any case, the passivation layer is suitable for protecting the SiC substrate surface from reacting with oxidizing components or being contaminated by other contaminants or reaction products such as carbon contaminations obtained from decomposition reactions of SiC, for example. The passivation layer may also passivate the SiC surface on a microscopic level, that means by reducing the number of dangling bonds and trapping centers.

The surface passivation may comprise annealing the semiconductor substrate surface in a passivation gas atmosphere comprising a gas selected of ammonia or an oxide of nitrogen or a combination thereof. In this case, the H₂ preclean treatment (Step A) of the surface may be carried out before the surface passivation (Step G). In some examples, also the deposition of a dielectric layer (Step I) may be carried out before the passivation of the SiC / dielectric interface is carried out by annealing (Step M in Fig. 1) the stack of layers together with the semiconductor substrate. This annealing may be optional if a sufficient passivation of the SiC substrate surface has been provided beforehand by a separate layer for example.

In some examples, the cleaning using, e.g. hydrogen as precleaning agent (e.g., fluid), and the passivating of the surface area can be carried out in one step or within the same process furnace without exposing the cleaned surface to an oxidizing atmosphere after the cleaning of the surface until the passivating step, in some examples until the end of the passivating step. More particularly, the presence of a non-oxidizing atmosphere may be observed if the substrate or wafer is handled at temperatures above about 50°C. Below this temperature, it is possible that the cleaned substrate surface may be not affected by any oxidizing atmosphere due to the low reactivity of the bonds and particles present at the substrate surface. Therefore, in some examples, the handling of the wafers in the cleaning room atmosphere may be possible for short times even though the cleaning room atmosphere may be considered as an oxidizing atmosphere. However, higher temperatures should be avoided. Preferably, the absence of any oxidizing atmosphere may result in improved cleaning results and higher reliability but may be decided from product to product. Sometimes. it is a consideration of the costs when deciding that observation of a high defined environment is needed or not. Any of the following processing steps, e.g. a dielectric layer formation, do not necessarily need the absence of the oxidizing atmosphere in case the surface area already has been passivated by the preclean and/or the passivating treatment. If a suitable passivation of the precleaned surface of the semiconductor substrate has been obtained in one of the aforementioned treatments, a rearrangement or any reaction under the formation of silicon oxides or carbon clusters or other contaminants are, thus, avoided or primarily at least limited in such a manner that the goal of the improvements explained herein is not affected. Nevertheless, the absence of any kind of oxidative species can be maintained until the end of the deposition of the dielectric layer above the SiC semiconductor substrate to minimize the risk of any unforeseeable contaminations or unwanted reactions which usually are detectable in the presence of oxidative species on the cleaned surface of semiconductor substrates, especially SiC substrates.

More particularly, the inert atmosphere or the non-oxidative species containing atmosphere during and after conducting the precleaning treatment allows to remove auto-doping residuals caused by surface rearrangement. Native oxide residuals (SiOₓC_{y}) or carbon clusters or other unwanted contaminants at the semiconductor surface, e.g. the SiC surface area of the semiconductor substrate, that generally are present after SACOX etching and cleaning during the formation of the SiC semiconductor surface to be processed can be removed or at least reduced in a significant amount by the precleaning step so that the afore-mentioned objectives are achieved. In case hydrogen is used in the precleaning step, a passivation of the surface with hydrogen for the subsequent gate dielectric deposition can be obtained. Alternatively, an interface formation under a nitrogen containing atmosphere can be carried out to prepare the SiC substrate for the subsequent dielectric deposition treatment.

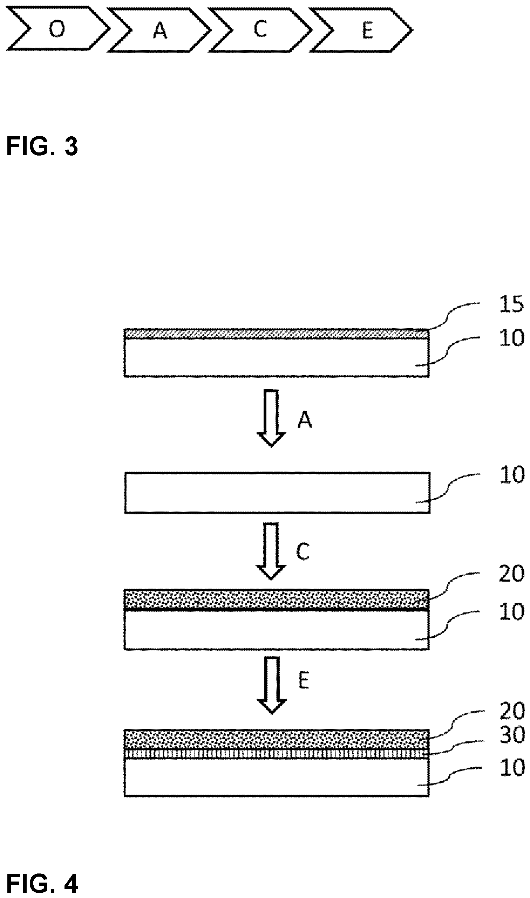

Generally, the methods descried herein encompass depositing a dielectric layer above the cleaned surface of the semiconductor substrate (e.g., Step I in Fig. 1 or Step C in Fig. 3). Above does mean in this regard the direct deposition of dielectric layer material 20 on the SiC substrate surface 10 or the deposition via an intermediate layer such as, for example, a passivation layer 30 as described with regard to the first embodiment (cf. Fig. 2). In some examples, the deposition of the dielectric layer, thus, comprises a deposition of the gate dielectric material on the cleaned and passivated surface area of the semiconductor substrate in a non-oxidizing atmosphere. Thus, the deposition may be carried out without exposing the cleaned and passivated surface of the semiconductor substrate to any oxidative species until the dielectric layer formation. Lack of an oxidizing atmosphere may be observed in this embodiment at least after the surface has been cleaned by the precleaning treatment as described above and at least until the end of the passivation treatment, in some examples until the end of the dielectric layer deposition. If technically possible and suitable, the whole process can be performed without exposing the processed surfaces to an oxidizing atmosphere to avoid native oxide formation or any rearrangement reactions at the interface between the semiconductor substrate and the dielectric layer.

The dielectric layer formation, that means the gate dielectric formation, may be carried out via a deposition process, more particularly, a non-oxidative deposition. Exemplified deposition processes for the gate dielectric material are low pressure chemical vapor deposition (LPCVD), e.g. with tetra ethoxy silane (TEOS), low or high temperature oxide deposition (LTO, HTO), or atomic layer deposition (ALD), or comparable deposition processes commonly used in the semiconductor manufacturing. During these processes oxygen as carrier gas may be used as long as it does not act as oxidizing species at the deposition conditions (e.g. temperature and pressure) used. More particularly, the suppression of oxidation may be observed to reduce or avoid intermediate oxidation of the SiC surface area. In case of a thermal interface formation, the gate dielectric deposition may be done in-situ with the precleaning treatment, for example in the same reaction furnace.

In a second embodiment, the method of forming a semiconductor substrate may comprise the steps of forming a semiconductor substrate comprising silicon carbide at a surface thereof. This embodiment is shown in Figures 3 and 4. The SiC formation may be done as described with regards to the first embodiment (Step O). Thereafter, a H₂ preclean treatment (Step A) is carried out. This preclean treatment may be the same as described with regard to the first embodiment. After the preclean treatment, a dielectric layer is formed directly on the cleaned SiC surface (Step C), e.g., in line with the dielectric layer formation processes described with regard to the aforementioned embodiments.

According to the embodiment shown in Figures 3 and 4, the method further comprises annealing the dielectric layer after the formation (e.g. deposition) of the gate dielectric material (e.g., Step E in Figs. 3 and 4). This can be done in an inert atmosphere, e.g. under N₂ or argon, if a passivation layer 30 at the SiC / dielectric interface has already been formed before the deposition of the dielectric layer as described in the first embodiment, for example. In case of the deposition of the dielectric layer 20 (dielectric material) directly on the cleaned surface of the SiC substrate 10, that means without the intermediate passivation of the cleaned surface, the annealing may be carried out in a nitrogen oxide containing atmosphere, thus producing the passivation layer 30 in situ at the interface of the gate dielectric and SiC. Examples of the nitrogen oxides are any NOₓ in general, in some examples nitric oxide (NO), generally known as a non-oxidative oxide of nitrogen. The annealing in an inert atmosphere or in a nitrogen containing atmosphere also provides a densification of the gate dielectric, especially, in case the gate dielectric formation and the interface layer formation, that means the formation of the passivation layer 30, is prepared in situ in one process step.

Another embodiment of the method for forming a semiconductor device comprises forming (e.g. depositing) a dielectric layer directly on the cleaned surface of the semiconductor substrate without exposing the cleaned surface to an oxidizing atmosphere after the cleaning of the surface and during the dielectric layer formation. Therefore, the formation of the dielectric layer, e.g. the gate oxide (GOX) layer, may be carried out in situ, that means within the same process furnace as the precleaning treatment. The atmosphere during the precleaning treatment and the formation of the dielectric layer may be carried out in an atmosphere without any oxidative species to reduce the risk for generating native oxides at the SiC surface.

After the gate dielectric material formation, an annealing of the semiconductor substrate including the dielectric layer in a passivation gas atmosphere comprising gas species selected of ammonia or an oxide of nitrogen, or a combination thereof may be carried out. An exemplified oxide for the interface layer to be prepared by this annealing process may be nitric oxide (NO). Thereby, the interface layer comprising nitrogen components at the interface of the SiC semiconductor substrate and the gate dielectric layer is obtained during the annealing treatment. It has been shown that the interface layer may have a positive impact on the SiC dielectric / gate dielectric interface and, therefore, an improved channel mobility. This may result in an improved ON-resistance, e.g. a significant reduction of the ON-resistance, compared to devices obtained without the precleaning treatment.

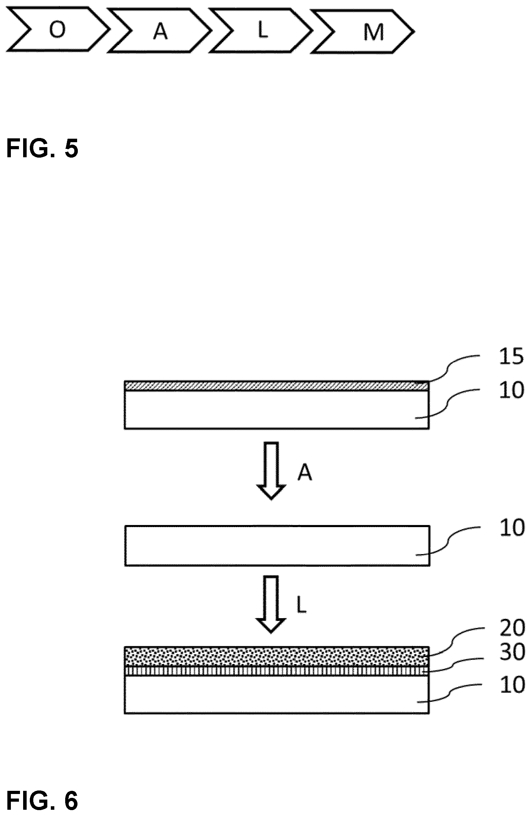

In Figures 5 and 6, another embodiment of the method is described in more detail. In this embodiment, the substrate surface 10 is cleaned from the oxide or carbon contaminants 15 by the herein described H₂ preclean treatment (Step A). The same reactants and the same reaction conditions as described in the other embodiments can be used herein as well. Instead of forming a passivation layer 30 and forming a gate dielectric layer 20 separately, these two processes can be carried out within one oxide forming or oxide deposition step (L). Optionally, this step may be followed by an annealing step (Step M in Fig. 6) in order to generate the specific SiC / gate dielectric interface layer 30 which also acts as passivation layer in this embodiment.

Likewise in other examples, the semiconductor substrate surface may be treated with a gaseous agent which may comprise a non-oxidizing gas. More specifically, the cleaning of the surface area may comprise exposing the semiconductor substrate surface to hydrogen or hydrochloric acid gas atmosphere. Thus, exemplified non-oxidizing gases are hydrogen (H₂) or hydrochloric acid (HCl) which both more act as reducing agent than oxidizing agents.

In case a hydrogen atmosphere is used for carrying out the cleaning of the semiconductor substrate surface, especially the SiC surface area, the precleaning treatment may be carried out at a temperature below 1350 °C and a pressure range below 0.1 MPa. Usual reaction times at these temperatures and pressures may be in a range of about 5 to 60 minutes, for example about 10 to 30 minutes, more exemplary about 10 to 20 minutes, in a particular example about 15 minutes.

In general, the methods as described herein may be applied to form a silicon substrate / gate dielectric interface of a power transistor in SiC technology. The use of the formation of a non-oxidative atmosphere before or during the formation of the SiC / gate dielectric interface layer and the provision of a NO interface layer has been investigated and it could be shown that the aforementioned objectives could be solved. More particularly, the precleaning treatment and/or the formation of an interface layer during the passivation treatment before the deposition of the gate dielectric material may result in an improved, that means, increased channel mobility. Moreover, the formation of an interface layer comprising nitric oxide, for example, during the annealing treatment after the deposition of the gate dielectric material may also result in an improved channel mobility. Thus, in some examples (e.g. a 1200 V MOSFET device), the ON-resistance has been significantly reduced when using the H₂ preclean treatment according to any of the herein described embodiments compared to devices produced without the precleaning step or without the formation of an interface layer, e.g. a NO layer.

In some examples, it has been shown that the trench form has more distinct edges, especially around areas where doping changes when the preclean treatment has been used. In addition, differences in oxide thicknesses and hydrogen peaks at the SiC / gate dielectric interface may be used to detect the use of a H₂ preclean treatment in products obtained from methods described herein.

As used herein, the terms *"having", "containing", "including", "comprising"* and the like are open ended terms that indicate the presence of stated elements or features, but do not preclude additional elements or features. The articles "*a*", "*an*" and *"the"* are intended to include the plural as well as the singular, unless the context clearly indicates otherwise.

It is to be understood that the features of the various embodiments described herein may be combined with each other, unless specifically noted otherwise. Although specific embodiments have been illustrated and described herein, it will be appreciated by those of ordinary skill in the art that a variety of alternate and/or equivalent implementations may be substituted for the specific embodiments and examples shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. Method of forming a semiconductor device comprising:
forming a semiconductor substrate comprising silicon carbide at a surface thereof;
cleaning a surface area of the semiconductor substrate by removing oxide species, carbon clusters, or other contaminants,
forming a dielectric layer above the cleaned surface of the semiconductor substrate without exposing the cleaned surface to an oxidizing atmosphere after the cleaning of the surface until the end of the dielectric layer formation,
wherein the method further provides a surface passivation at the interface of the cleaned surface of the semiconductor substrate and the dielectric layer.

2. Method of forming a semiconductor device according to claim 1 comprising:
passivating the cleaned surface area; and
forming a dielectric layer on the passivated surface comprising a formation of a gate dielectric material on the cleaned and passivated surface area of the semiconductor substrate.

3. Method according to any of claims 1 or 2, wherein the cleaning of the surface area comprises treating the semiconductor substrate surface with a gaseous agent comprising non-oxidative species.

4. Method according to any of claims 1 to 3, wherein the cleaning of the surface area comprises exposing the semiconductor substrate surface to hydrogen or hydrochloric acid gas atmosphere.

5. Method according to claim 4, wherein the cleaning in hydrogen atmosphere is carried out at a temperature below 1350 °C and a pressure range below 0.1 MPa.

6. Method according to any of the aforementioned claims, wherein the surface passivation comprises annealing the semiconductor substrate surface in a passivation gas atmosphere comprising a gas selected of ammonia or an oxide of nitrogen or a combination thereof.

7. Method according to any of the aforementioned claims, wherein the cleaning and passivating of the surface area can be carried out in one step or within the same process furnace without exposing the cleaned surface to an oxidizing atmosphere after the cleaning of the surface until the passivating step, wherein the dielectric layer formation step do not need the absence of the oxidizing atmosphere.

8. Method according to any of the aforementioned claims, wherein forming of the dielectric layer comprises a deposition of the gate dielectric material on the cleaned and passivated surface area of the semiconductor substrate in a non-oxidizing atmosphere.

9. Method according to any of the aforementioned claims, further comprising annealing the dielectric layer after the formation of the gate dielectric material.

10. Method for forming a semiconductor device according to claim 1 comprising:
forming a dielectric layer directly on the cleaned surface of the semiconductor substrate without exposing the cleaned surface to an oxidizing atmosphere after the cleaning of the surface and during the dielectric layer formation, and
annealing the dielectric layer after a gate dielectric material formation in a passivation gas atmosphere comprising gas species selected of ammonia or an oxide of nitrogen, or a combination thereof.

11. Method according to claim 10, wherein the cleaning of the surface area comprises treating the semiconductor substrate surface with a gaseous agent comprising a non-oxidizing gas.

12. Method according to any of claims 10 or 11, wherein the cleaning of the surface area comprises exposing the semiconductor substrate surface to hydrogen or hydrochloric acid gas atmosphere.

13. Method according to any of claims 10 to 12, wherein the cleaning in hydrogen atmosphere is carried out at a temperature below 1350 °C and a pressure range below 0.1 MPa.

14. Method according to any of the aforementioned claims, wherein the method is applied to form the silicon substrate / gate dielectric interface of a power transistor in SiC technology.
